# EUROPÄISCHE PATENTSCHRIFT

(11) **EP 0 490 214 B1**
(45) Veröffentlichungstag und Bekanntmachung des Hinweises auf die Patenterteilung: **24.07.1996**
(21) Anmeldenummer: 91120691.0
(22) Anmeldetag: 02.12.1991
(51) Int. Cl.: H04M 1/03, H04R 1/06, H01R 13/24

(54) **Kontaktanordnung zwischen in einem Handapparat einer Fernsprechstation angeordneten Wandlern und einer Leiterplatte**
Contact assembly between a transducer and a circuit board arranged in a handset of a subscriber set
Dispositif de contact entre un transducteur et une plaquette de circuit agencés dans le combiné d'un porte téléphonique

(30) Priorität: 12.12.1990 DE 9016811 U
(43) Veröffentlichungstag der Anmeldung: 17.06.1992
(73) Patentinhaber: SIEMENS AKTIENGESELLSCHAFT, 80333 München (DE)
(72) Erfinder: Höpken, Reiner, Dipl.-Ing., W-4230 Wesel 13 (DE); Osterloh, Hans Dieter, Dipl.-Ing., W-4292 Rhede (DE); Reuschel, Jürgen, W-4290 Bocholt (DE)

(56) Entgegenhaltungen:
- DE-A- 3 140 746
- DE-U- 9 016 811

## Beschreibung

Bei Kompaktfernsprechern sind im Handapparat der Fernsprechstation alle wesentlichen Elemente zur Herstellung einer Fernsprechverbindung wie z. B. Wähltastatur, Hör- und Einsprachekapsel sowie eine elektrische und elektronische Bauteile tragende Leiterplatte untergebracht. Dabei erfolgt die Befestigung des jeweiligen elektroakustischen Wandlers im Handapparategehäuse mittels eines auf dem Wandler aufklebbaren elastischen, z. B. aus Gummi bestehenden Druckstückes oder mittels eines am Gehäuse angeordneten, vorgespannten und den Wandler übergreifenden Drahtbügels, wobei durch diese genannten Teile der Wandler akustisch dicht an die Schalldurchlaßöffnungen angepreßt wird. Die elektrische Kontaktierung zwischen den Wandlern und der Leiterplatte wurde mittels eines zweiadrigen, an seinen freien Enden Steckschuhe aufweisenden Kabels vorgenommen, wobei die Steckschuhe jeweils auf ihnen konturmäßig entsprechende Steckzungen am Wandler und an der Leiterplatte aufgebracht wurden.

Der vorliegenden Erfindung liegt nunmehr die Aufgabe zugrunde, ein Kontaktteil zur Kontaktierung von Wandler- und Leiterplatte aufzuzeigen, das außer der elektrischen Kontaktgabe auch eine mechanisch sichere Festlegung des Wandlers im Handapparat gewährleistet.

Diese Aufgabe wird dadurch gelöst, daß die Kontaktanordnung als Kontaktfeder gestaltet ist, die jeweils mit einem Steckbereich auf die in Schächte des elektroakustischen Wandlers angeordneten Steckzungen aufbringbar ist und sich mit einem diesem Steckbereich gegenüberliegenden Bereich an einer Kontaktfläche der Leiterplatte unter Vorspannung abstützt.

Mittels dieser Kontaktfeder werden zwei Funktionen mit einem einzigen Teil erfüllt. Einerseits wird in einfacher Weise eine elektrische Verbindung zwischen dem Wandler und der Leiterplatte, die gegebenenfalls auch aus einem leitenden Material (z. B. einer auf der Gehäuseoberschale des Handapparates aufgebrachten Metallfolie) bestehen kann, sichergestellt, zum anderen wird aufgrund der Verspannung der Kontaktfeder der notwendige Druck erzeugt, um eine mechanisch sichere und akustisch dichte Anlage des Wandlers an die im Handapparategehäuse vorgesehenen Schalldurchlaßöffnungen zu erreichen.

Dabei kann die Kontaktfeder aus einem bügelförmigen, sich an der Leiterplatte abstützenden Bereich und sich an diesen Bereich anschließenden Endbereichen bestehen, die U-förmig voneinander wegweisend abgebogen sind, wobei die Endbereiche auf einem Teil ihrer Länge parallel zueinander verlaufen und eine Steckaufnahme bilden. Bei der Montage des Handapparates können somit die Kontaktfedern zunächst auf die in Schächten der Wandler angeordneten Steckzungen aufgebracht werden. Beim anschließenden Einbringen der Leiterplatte in den Handapparat, was z. B. durch die Leiterplatte übergreifende Rasthaken erfolgen kann, preßt sich der bügelförmige Bereich der Kontaktfeder unter Verformung dieses Bereiches an die Kontaktflächen auf der Leiterplatte an, wodurch der benötigte Druck auf den Wandler bewirkt wird.

Gemäß einer bevorzugten Ausführungsform können die sich an die Steckaufnahme anschließenden Bereiche der Kontaktfeder so gestaltet sein, daß sie sich im aufgesteckten Zustand an der Wandung des die Steckzunge aufnehmenden Schachtes abstützen. Dadurch wird einmal der Aufsteckweg der Steckaufnahme auf die betreffende Steckzunge im Wandler begrenzt und zum anderen ein Anlagebereich der Kontaktfeder an der Schachtwandung geschaffen, der ein sicheres Anpressen des Wandlers an die Schalldurchlaßöffnungen gewährleistet.

Die Erfindung soll im folgenden anhand eines Ausführungsbeispiels näher erläutert werden.

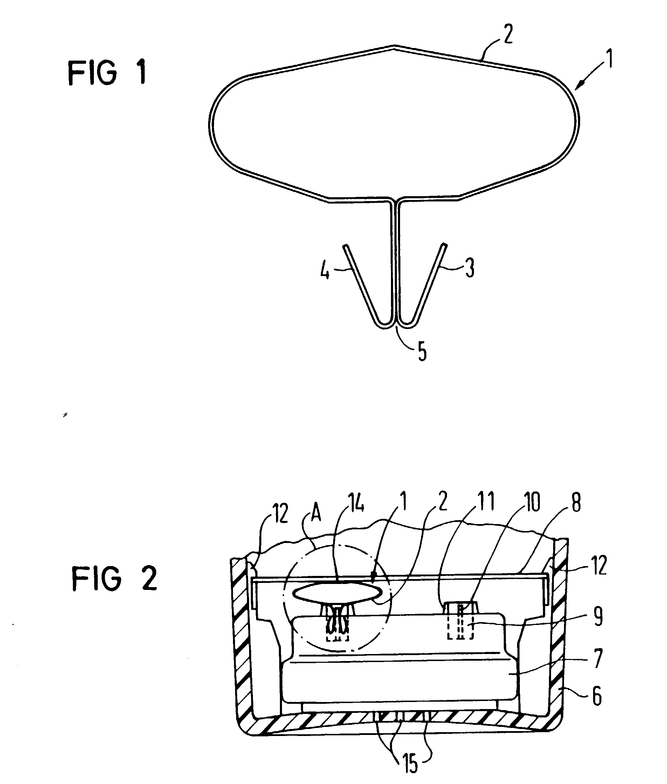

Es zeigt
Figur 1 die Kontaktfeder in einer Seitenansicht,
Figur 2 die Kontaktfeder im eingebauten Zustand in einem teilweise geschnittenen Handapparateteil,

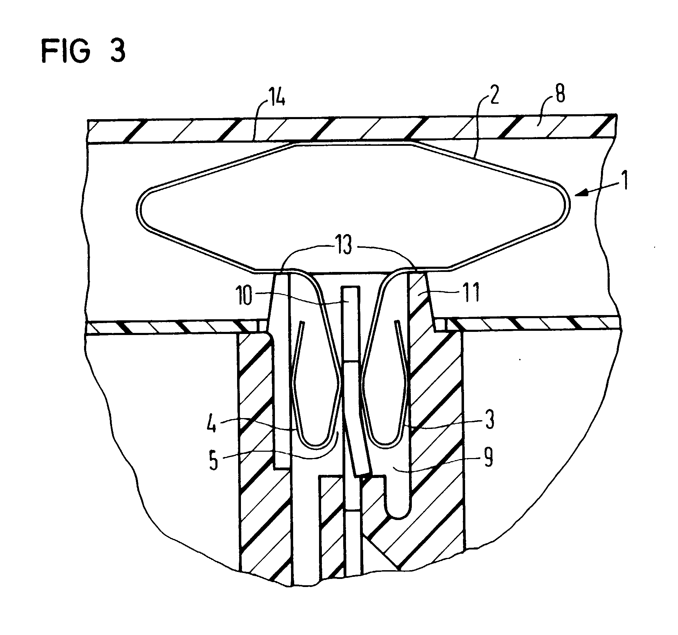

Figur 3 den Kreisausschnitt A in einem vergrößerten Maßstab.

Die Kontaktfeder 1 soll dazu verwendet werden, zwischen einem elektroakustischen Wandler in einem Handapparat einer Fernsprechstation und einer ebenfalls im Handapparat angeordneten Leiterplatte eine elektrische Verbindung herzustellen. Die Kontaktfeder 1 besteht im wesentlichen aus einem bügelförmigen Bereich 2 und den beiden nach außen etwa U-förmig voneinander weisend abgebogenen freien Endbereichen 3 und 4. Die freien Endbereiche 3 und 4 sind so gestaltet, daß sie auf einen Teil ihrer Länge parallel zueinander verlaufen und somit eine Steckaufnahme 5 bilden.

Um eine elektrische und mechanische Verbindung eines im Handapparat 6 angeordneten elektroakustischen Wandlers 7 und der im Handapparat 6 befestigten Leiterplatte 8 herzustellen, wird die Kontaktfeder 1 zunächst mit ihrer Steckaufnahme 5 auf die im Wandler 7 in einem Schacht 9 angeordnete Steckzunge 10 aufgedrückt. Dabei stützt sich die Kontaktfeder 1 mit ihren der Steckaufnahme 5 benachbarten bügelförmigen Bereichen 13 an der die Außenkonturen des Wandlers 7 überragenden Wandung 5 des Schachtes 9 ab. Nach dem Einbringen der Leiterplatte 8 in den Handapparat 6, was z. B. durch die Leiterplatte 8 übergreifende hakenförmige Rastelemente 12 erfolgen kann, stützt sich die Kontaktfeder unter leichter Verformung mit ihrem der Steckaufnahme 5 abgewandten Bereich an einer auf der Leiterplatte 8 aufgebrachten Kontaktfläche 14 ab. Aufgrund des durch die Verformung der Kontaktfeder 1 bewirkten Druckes auf den Wandler 7 wird dieser über den Bereich 13 akustisch dicht gegen die Schalldurchlaßöffnungen 15 im Handapparat 6 angepreßt.

## Patentansprüche

1. Kontaktanordnung zwischen in einem Handapparat einer Fernsprechstation angeordneten elektroakustischen Wandlern (7) und einer Leiterplatte (8), **dadurch gekennzeichnet,** daß die Kontaktanordnung als Kontaktfeder (1) gestaltet ist, die jeweils mit einem Steckbereich (5) auf die in Schächten (9) des elektroakustischen Wandlers (7) angeordneten Steckzungen (10) aufbringbar ist und sich mit einem diesem Steckbereich gegenüberliegenden Bereich (13) an einer Kontaktfläche (14) der Leiterplatte (8) unter Vorspannung abstützt.

2. Kontaktanordnung nach Anspruch 1, **dadurch gekennzeichnet,** daß die Kontaktfeder (1) aus einem bügelförmigen, sich an der Leiterplatte abstützenden Bereich (2) und sich an diesen Bereich (2) anschließenden Endbereichen (3, 4) besteht, die U-förmig voneinander wegweisend abgebogen sind, wobei die Endbereiche (3, 4) auf einem Teil ihrer Länge parallel zueinander verlaufen und eine Steckaufnahme (5) bilden.

3. Kontaktanordnung nach Anspruch 1, **dadurch gekennzeichnet,** daß die sich an die Steckaufnahme (5) anschließenden Bereiche (13) der Kontaktfeder (1) so gestaltet sind, daß sie sich im aufgesteckten Zustand an der Wandung (11) des die Steckzungen (10) aufnehmenden Schachtes (9) abstützen.

## Claims

1. Contact assembly between electro-acoustic transducers (7) arranged in a handset of a telephonic station, and a printed circuit board (8), characterized in that the contact assembly is designed as a contact spring (1) which can be applied, in each case, with a plug-in region (5), to the plug-in tongues (10) arranged in shafts (9) of the electro-acoustic transducer (7), and is supported, with prestressing, with a region (13) lying opposite this plug-in region, on a contact face (14) of the printed circuit board (8).

2. Contact arrangement according to Claim 1, characterized in that the contact spring (1) comprises a strap-shaped region (2), supported on the printed circuit board, and end regions (3, 4) which adjoin this region (2) and are bent pointing away from one another in a U shape, the end regions (3, 4) running parallel to one another over part of their length and forming a plug-in receptacle (5).

3. Contact arrangement according to Claim 1, characterized in that the regions (13), adjoining the plug-in receptacle (5), of the contact spring (1) are designed in such a way that, in the plugged-on state, they are supported on the wall (11) of the shaft (9) which receives the plug-in tongues (10).

## Revendications

1. Dispositif de contact entre des transducteurs (7) électro-acoustiques montés dans un combiné d'un poste téléphonique et une plaquette (8) à circuits imprimés, caractérisé en ce que le dispositif de contact est sous forme d'un ressort (1) de contact, qui peut être mis en place par une zone (5) d'enfichage sur les languettes (10) d'enfichage montées dans des puits (9) du transducteur (7) électro-acoustique et qui prend appui par une zone (13) opposée à cette zone d'enfichage, par précontrainte, sur une surface (14) de contact de la plaquette (8) à circuits imprimés.

2. Dispositif de contact suivant la revendication 1, caractérisé en ce que le ressort (1) de contact est constitué d'une zone (2) en forme d'étrier et prenant appui sur la plaquette à circuits imprimés et de zones (3, 4) d'extrémité, qui se raccordent à cette zone (2) et qui sont courbées en U en s'éloignant l'une de l'autre, les zones (3, 4) d'extrémité s'étendant parallèlement l'une à l'autre sur une partie de leur longueur et formant un logement (5) d'enfichage.

3. Dispositif de contact suivant la revendication 1, caractérisé en ce que les zones (13), se raccordant au logement (5) d'enfichage, du ressort (1) de contact sont formées de telle sorte qu'elles prennent appui, à l'état enfiché, sur la paroi (11) du puits (9) recevant les languettes (10) d'enfichage.
